# EUROPÄISCHE PATENTSCHRIFT

(11) **EP 0 272 384 B1**
(45) Veröffentlichungstag und Bekanntmachung des Hinweises auf die Patenterteilung: **06.11.1996**
(21) Anmeldenummer: 87113672.7
(22) Anmeldetag: 18.09.1987
(51) Int. Cl.: H01L 27/144, G02B 6/12, G02B 6/42, H01L 29/778, H01L 31/105

(54) **Monolithisch integrierter Photoempfänger**
Monolithic integrated photodetector
Photodétecteur intégré monolithique

(30) Priorität: 24.12.1986 DE 3644410
(43) Veröffentlichungstag der Anmeldung: 29.06.1988
(73) Patentinhaber: Licentia Patent-Verwaltungs-GmbH, 60596 Frankfurt (DE)
(72) Erfinder: Dämbkes, Heinrich, Dr.-Ing., D-7900 Ulm (DE); König, Ulf, Dr.-Ing., D-7900 Ulm (DE); Haspeklo, Horst, Dr.rer.nat., D-7915 Elchingen (DE)
(74) Vertreter: Weber, Gerhard, Dipl.-Phys.

(56) Entgegenhaltungen:
- EP-A- 0 064 829
- EP-A- 0 133 709
- CA-A- 980 451
- US-A- 4 136 928
- APPLIED PHYSICS LETTERS, Band 46, Nr. 7, 1. April 1985, Seiten 681-683, American Institue of Physics, New Jork, US; C.Y. CHEN et al.: "Monolithic integrated receiver front end consisting of a photoconductive detector and a GaAs selectively doped heterostructure transistor"
- PATENT ABSTRACTS OF JAPAN, Band 7, Nr. 190 (E-194) [1335], 19. August 1983; & 58 92 259 (FUJITSU K.K.) 01-06-1983
- INTERNATIONAL ELECTRON DEVICES MEETING, Washington, D.C., 5. - 7. Dezember 1983, Seiten 689-691, IEEE, New York, US; C. DUBON et al.: "Double heterojunction GaAs-GaA1As bipolar transistors grown by MOCVD for emitter coupled logic circuits"
- APPLIED PHYSICS LETTERS, Band 47, Nr. 3, 1. August 1985, Seiten 186-187, American Institute of Physics, New York, US; K. HIRUMA et al.:"Low loss GaAs optical waveguides grown by the metalorganic chemical vapor deposition method"

## Beschreibung

Die Erfindung betrifft einen monolithisch integrierten Photoempfänger nach dem Oberbegriff der Patentansprüche 1 und 14. Photoempfänger gemäß der Erfindung sind für Meß- oder Nachrichtenübertragungssysteme geeignet. Vorbekannte Lösungen von monolithisch integrierten optoelektronischen Empfängerschaltungen sind beispielsweise eine Kombination einer PIN-Photodiode und eines JFET (Junction Field Effect Transistor) auf InGaAs Basis ( Lit.: R.E.Nahory, R.F.Leheny, Proc.Soc.Photo-Optical Instrum. Eng. 272, S.32-35, 1981) oder eine Kombination einer PIN-Photodiode und eines Heterobipolartransistor aus InP/InGaAsP-Verbindungen. Die PIN-Photodioden sind jedoch lediglich für senkrecht zur Halbleiterschichtenfolge eingestrahltes Licht empfindlich und die Ankopplung eines optischen Wellenleiters kann nur hybrid erfolgen. Diese optischen Empfängerschaltungen haben den Nachteil, daß sie lange Schaltzeiten und hohe Rauschzahlen besitzen. Die hybride Ankopplung des Wellenleiters hat außerdem einen hohen optischen Leistungsverlust zur Folge.

Eine Ankopplung eines Wellenleiters an eine PIN-Diode mit integriertem Verstärker ist auch aus der CA-A-980 451 bekannt.

Ferner ist aus der EP-A- 0 133 709 ein monolithisch integrierter Photoempfänger bekannt, welcher aus einer PIN-Photodiode und einem zugehörigen Verstärker besteht. Lediglich ist eine hybride Ankopplung eines Wellenleiters an diesen Photoempfänger möglich.

Aus der US-Patentschrift 4,136, 928 ist eine integrierte Anordnung von Wellenleiter und Detektor bekannt. Ein Laser ist optisch an einen untenliegenden dielektrischen Wellenleiter angekoppelt, der wiederum an einen optischen Detektor gekoppelt ist. Eine integrierte Anordnung von Wellenleiter, Detektor und Verstärker wird in D1 nicht angegeben.

Der Erfindung liegt daher die Aufgabe zugrunde, einen schnellschaltenden und rauscharmen monolithisch integrierten Photoempfänger anzugeben, an den ein optischer Wellenleiter durch monolithische Integration angekoppelt ist.

Diese Aufgabe wird gelöst durch die im kennzeichnenden Teil der Patentansprüche 1 und 14 angegebenen Merkmale. Vorteilhafte Ausgestaltungen und Weiterbildungen sind den Unteransprüchen entnehmbar.

Die monolithisch integrierte optische Empfängerschaltung ist für einen in der Lichtleitfasertechnik nützlichen Wellenlängenbereich λ von vorzugsweise 0,8 ≤ λ ≤ 1,55µm geeignet.

Ein Vorteil der Erfindung besteht darin, daß durch die monolithische Integration von Wellenleiter, optischem Empfänger und dazugehörigem Verstärker ein geringerer Leistungsverlust auftritt als bei einer hybriden Bauweise. Außerdem ist das Herstellungsverfahren einer monolithisch integrierten Empfängerschaltung gemäß der Erfindung dank gemeinsamen Nutzung der Halbleiterschichten in den Einzelbauelementen Wellenleiter, Photodiode, Verstärker wesentlich einfacher und kostengünstiger als die hybride Bauform.

Die Erfindung wird im folgenden anhand von Ausführungsbeispielen unter Bezugnahme auf schematische Zeichnungen näher erläutert.
Die Figuren 1a, 1b, 1c zeigen Querschnitte von unterschiedlichen Ausführungsformen von optischen Wellenleitern und den Brechungsindexverlauf in den Halbleiterschichten für parallel zu den Halbleiterschichten eingestrahltes Licht.

Fig. 2 zeigt eine Aufsicht auf eine mesa-geätzte, monolithisch integrierte Empfängerschaltung aus einer PIN-Photodiode 17 mit angekoppeltem Wellenleiter 16 und einem HEMT (High Electron Mobility Transistor) 18.

Die Figuren 3 bis 7 zeigen Längsschnitte von verschiedenen Ausführungsformen von PIN-HEMT-Photoempfängern mit angekoppeltem Wellenleiter. PIN-HEMT-Photoempfänger ist eine Kurzbezeichnung für eine optische Empfängerschaltung, die aus einer PIN-Photodiode und einem HEMT besteht.

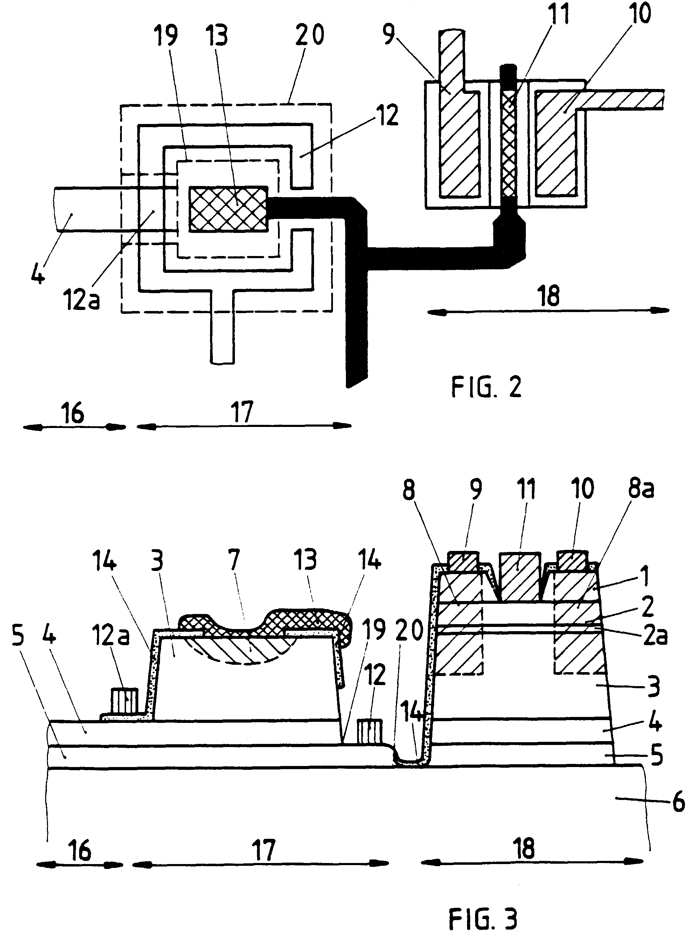

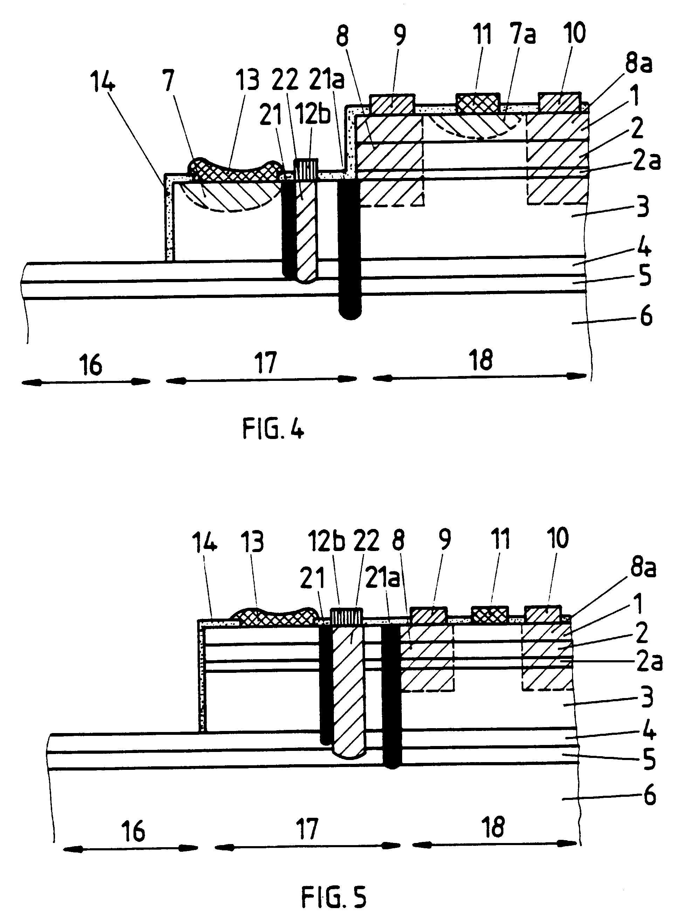

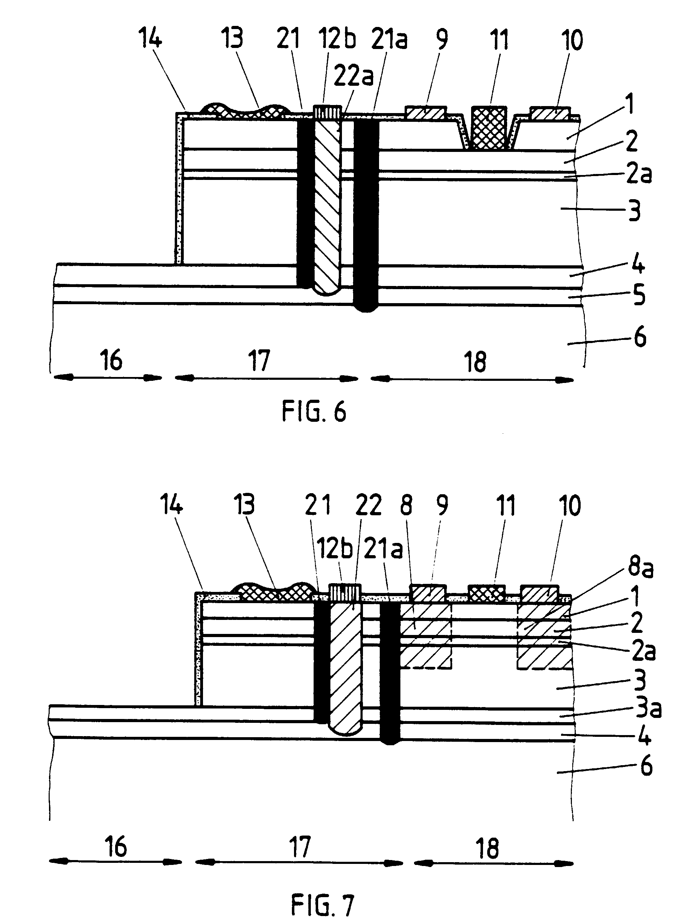

Die Erfindung beruht darauf, daß unterhalb eines optischen Empfängers ein Wellenleiter seitlich angekoppelt wird, derart, daß die Halbleiterschichten des Wellenleiters auch Bestandteil des optischen Empfängers sind. Es entsteht ein stufenartiger Aufbau, da der Wellenleiter lediglich aus zwei Halbleiterschichten und der optische Empfänger aus mindestens drei Halbleiterschichten besteht. Der optische Empfänger ist vorteilhafterweise eine PIN-Photodiode 17 mit hohem Quantenwirkungsgrad. Der dazugehörige Feldeffektransistor ist als HEMT (High Electron Mobility Transistor) 18 ausgebildet, der für eine schnelle elektronische Signalverarbeitung geeignet ist. PIN-Photodiode 17 und HEMT 18 sind entweder in Mesabauweise (Fig. 3) oder quasi-planar (Fig. 4) oder planar (Fig.5 und Fig. 6) angeordnet. Im Fall der optischen Signalverarbeitung, z.B. Multiplexen oder Demultiplexen, besteht die integrierte optische Empfängerschaltung aus mehreren PIN-Photodioden mit angekoppelten Wellenleitern. Außerdem schließt die Erfindung die monolithische Integration von mehreren HEMT zur Bildung eines Vorverstärkers mit ein. In den Ausführungsbeispielen werden jedoch aus Gründen der Übersichtlichkeit lediglich Kombinationen einer PIN-Photodiode 17 mit angekoppeltem Wellenleiter 16 und eine HEMT 18 beschrieben.

Der erfindungsgemäße Photoempfänger ist so aufgebaut, daß das einfallende Licht parallel zu den Halbleiterschichten an die PIN-Photodiode 17 herangeführt wird. Die in den Ausführungsbeispielen angegebene Heterostruktur-Halbleiterschichtenfolge besteht aus mindestens fünf unterschiedlichen Halbleiterschichten. Die auf das Substrat 6 aufgewachsenen ersten beiden Halbleiterschichten 5,4 sind für die Lichtleitung ausgebildet. Deshalb sind im Bereich des Wellenleiters 16 bis auf die erste Halbleiterschicht 5 und die lichtführende Halbleiterschicht 4 alle weiteren Halbleiterschichten entfernt.

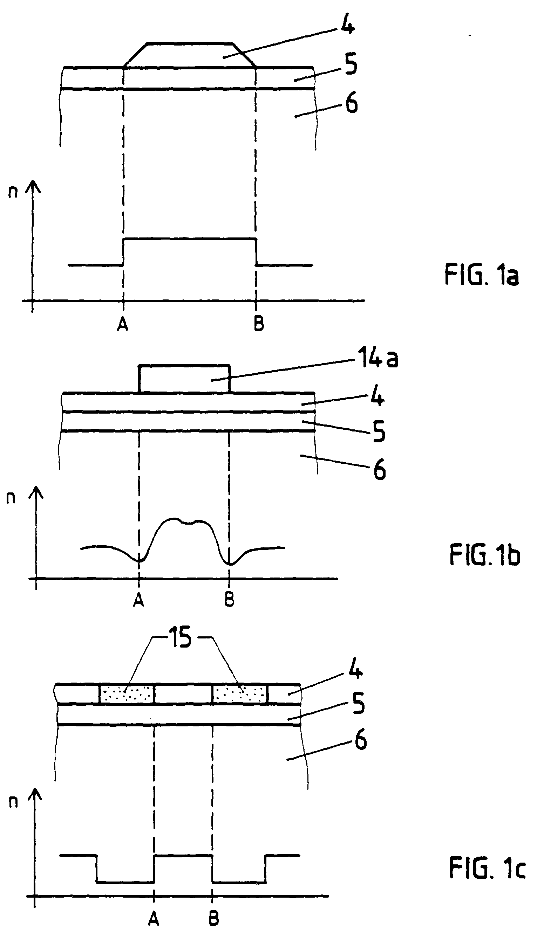

Um das Licht lediglich in der Halbleiterschicht 4 zu führen, besitzt die erste Halbleiterschicht 5 der Heterostruktur einen kleineren Brechungsindex als die darauf aufgewachsene, lichtführende Halbleiterschicht 4. Um eine geeignete Ankopplung des Wellenleiters 16 an die PIN-Photodiode 17 zu ermöglichen ist der Bereich, in dem das Licht in der Halbleiterschicht 4 geführt wird, räumlich begrenzt. Diese seitliche Begrenzung A, B des Lichtes in der Halbleiterschicht 4 erreicht man durch eine Änderung des Brechungsindex: der Brechungsindex muß in der Halbleiterschicht 4 seitlich abnehmen. Der optische Wellenleiter 16 kann deshalb unterschiedlich ausgebildet sein:
a) Die lichtführende Halbleiterschicht 4 ist mesa-geätzt, so daß der Brechungsindex n zum optisch dünneren Medium Luft abnimmt (Fig. 1a).
b) Auf die lichtführende Halbleiterschicht 4 ist ein Oxidstreifen 14a aufgebracht. An der Grenzfläche Halbleiterschicht/Oxidschicht 4, 14a wird dadurch eine mechanische Spannung erzeugt, die den Brechungsindex n der lichtführenden Halbleiterschicht 4 am Rand des Oxidstreifens 14a verringert (Fig. 1b).
c) In die lichtführende Halbleiterschicht 4 sind hochdotierte Zonen 15 implantiert, die einen kleineren Brechungsindex n besitzen als die lichtführende Halbleiterschicht 4 (Fig. 1c).
d) Auf die lichtführende Halbleiterschicht 4 ist ein metallischer Streifen aufgebracht, an den eine elektrische Spannung angelegt wird. Durch die elektrische Spannung wird im Bereich des metallischen Streifens der Bandabstand der Halbleiterschicht 4 verringert und somit der Brechungsindex n erhöht.

Gemäß den Figuren 3 bis 6 sind die erste Halbleiterschicht 5 und die darauf aufgewachsene lichtführende Halbleiterschicht 4 gemeinsamer Bestandteil des Wellenleiters 16 und der PIN-Photodiode 17. Die erste Halbleiterschicht 5 sorgt für optisches Confinement und dient gleichzeitig als leitende Kontaktschicht für eine niedrig dotierte Halbleiterschicht 3, die auf die Halbleiterschicht 4 aufgewachsen ist. Alternativ oder zusätzlich zur ersten Halbleiterschicht 5 kann eine n-dotierte Halbleiterschicht 3a oberhalb der lichtführenden Halbleiterschicht 4 angeordnet werden (Fig. 7). Dotierung und Bandabstand dieser Halbleiterschicht 3a sind so abgestimmt, daß sie einen Brechungsindex zwischen dem des Wellenleiters und dem der absorbierenden Halbleiterschicht 3 besitzt, um das Auskoppeln des geführten Lichtes an die Photodiode nicht zu beeinträchtigen. Die n-dotierte Halbleiterschicht 3a besitzt eine Dotierkonzentration von 10¹⁷ bis 5 · 10¹⁸cm⁻³ und eine Schichtdicke von o,5µm. Als Halbleitermaterial ist beispielsweise GaInAsP für die Halbleiterschicht 3a geeignet. Die zweite Elektrode 12b der PIN-Photodiode 17 kontaktiert die n-dotierte Halbleiterschicht 3a. Ist die n-dotierte Halbleiterschicht 3a zusätzlich zur ersten Halbleiterschicht 5 aufgebracht, so dient die erste Halbleiterschicht 5 lediglich als Pufferschicht zwischen Substrat 6 und der folgenden Heterostruktur.

Die Halbleiterschicht 3 ist als Absorptionsschicht der PIN-Photodiode 17 für das in der Halbleiterschicht 4 geführte Licht ausgebildet. Um das in der Halbleiterschicht 4 parallel geführte Licht fast vollständig (<90%) im Bereich der PIN-Photodiode 17 auszukoppeln, ist der Brechungsindex der absorbierenden Halbleiterschicht 3 größer als der der lichtführenden Halbleiterschicht 4. Da eine hohe Dotierung eine Verringerung des Brechungsindex bewirkt, ist die absorbierende Halbleiterschicht 3 schwach dotiert.

Damit die einzelnen Bauelemente des erfindungsgemäßen Photoempfängers aus einer Heterostruktur aufgebaut werden können, müssen die Halbleiterschichten für die einzelnen Bauelemente kompatibel sein. In den Ausführungsbeispielen sind verschiedene Alternativen für die Heterostruktur und die Bauformen des Photoempfängers angegeben.

In Ausführungsbeispiel 1 ist auf einem halbisolierenden Substrat 6, das z.B. aus InP besteht, eine Heterostruktur-Halbleiterschichtenfolge aus
- einer ersten n-dotierten Halbleiterschicht 5 aus InAlAs oder InAlAsP oder InGaAsP oder InP mit einer Ladungsträgerkonzentration von ungefähr 10¹⁷ bis 5·10¹⁸ cm⁻³ und einer Schichtdicke von etwa 0,2 bis 2 µm,
- einer n-dotierten Halbleiterschicht 4 aus InAlAs oder InAlAsP oder InGaAsP mit einer Ladungsträgerkonzentration von ungefähr 10¹⁵ bis 10¹⁷ cm⁻³und einer Schichtdicke von etwa 0,2 bis 2 µm,
- einer n-dotierten Halbleiterschicht 3 aus InGaAs mit einer Ladungsträgerkonzentration von 10¹⁴ bis 10¹⁶ cm⁻³ und einer Schichtdicke von etwa 2 bis 3 µm,
- einer undotierten Halbleiterschicht 2a aus InAlAs oder InP oder InGaAsP mit einer Schichtdicke von weniger als 20 nm,
- einer n-dotierten Halbleiterschicht 2 aus InAlAs oder InAlAsP oder InP mit einer Ladungsträgerkonzentration von 10¹⁷ bis 10¹⁸ cm⁻³ und einer Schichtdicke von 20 bis 100 nm,
- einer n-dotierten Halbleiterschicht 1 mit einer Ladungsträgerkonzentration von 1 bis 6·10¹⁸ cm⁻³ und einer Schichtdicke von ungefähr 10 bis 100 nm aufgewachsen.

Gemäß Fig. 3 sind im Bereich des Wellenleiters 16 die Halbleiterschichten 1 bis 3 und im Bereich der PIN-Photodiode die Halbleiterschichten 1,2,2a, weggeätzt. PIN-Photodiode 17 und HEMT 18 sind in Mesabauform angeordnet. In die n-dotierte Halbleiterschicht 3 der PIN-Photodiode 17 ist ein p-leitendes Gebiet 7 mit z.B. Mg oder Be implantiert, das eine Tiefe von etwa 0,1 bis 0,5 µm und eine Ladungsträgerkonzentration von 10¹⁷ bis 10¹⁹ cm⁻³ besitzt. Durch einen anschließenden kurzzeitigen Temperprozeß von ungefähr 10 Sekunden werden die durch die Implantation im Kristall entstandenen Schäden ausgeheilt. Eine erste Elektrode 13 der PIN-Photodiode 17 ist auf das p-implantierte Gebiet 7 aufgebracht. Eine zweite Elektrode 12 der PIN-Photodiode 17 kontaktiert die n-dotierte Halbleiterschicht 5.

Die zweite Elektrode 12 ist beispielsweise rechteckig ausgebildet und umschließt die mesa-geätzte PIN-Photodiode 17 gemäß Fig. 2. Mittels einer Kontaktbrücke 12a wird die Elektrode 12 über den Wellenleiter 16 geführt. Eine Isolierschicht 14 verhindert den Kontakt zwischen der n-dotierten Halbleiterschicht 4 und der Elektrode 12 im Bereich der Kontaktbrücke 12a. Die Bezugszeichen 19, 20 in den Fig. 2 und 3 bezeichnen die Mesa-Kanten der PIN-Photodiode 17.

Um Licht in der Halbleiterschicht 4 zu führen muß die erste Halbleiterschicht 5 einen größeren Bandabstand oder was gleichbedeutend ist, einen kleineren Brechungsindex besitzen als die lichtführende Halbleiterschicht 4. Für die im Ausführungsbeispiel 1 angegebene Heterostruktur kann bespielsweise die lichtführende Halbleiterschicht 4 aus InAlAs und die erste Halbleiterschicht 5 aus InAlAsP aufgebaut sein. Sind beide Halbleiterschichten 4,5 aus der gleichen Halbleiterverbindung aufgebaut, so müssen die Anteile der Elemente der Halbleiterverbindung unterschiedlich gewählt werden; besteht beispielsweise die lichtführende Halbleiterschicht 4 aus In₁₋ₓGaₓP_{1-y}As_{y} und die erste Halbleiterschicht 5 aus In₁₋ₓGaₓP_{1-z}As_{z} so muß z < y sein. Außerdem erreicht man durch eine höhere Dotierkonzentration der ersten Halbleiterschicht 5 einen kleineren Brechungsindex.

Source- und der Drain-Anschluß 9,10 des HEMT 18 mit einer Heterostruktur gemäß Ausführungsbeispiel 1 sind auf n-implantierten Gebieten 8,8a angebracht, die senkrecht zu den Halbleiterschichten 1,2,2a und 3 verlaufen. Source- und Drain-Anschluß 9,10 sind sperrfreie metallische Kontakte, die über die n-leitenden Gebiete 8,8a mit dem zweidimensionalen Elektronengas an der Grenzfläche 2a, 3 verbunden sind. Im Bereich des Gate-Anschlusses 11 des HEMT 18 ist die n-dotierte Halbleiterschicht 1 entfernt und der sperrende metallische Kontakt ist auf die n-dotierte Halbleiterschicht 2 aufgebracht.

Im Ausführungsbeispiel 2 ist der Photoempfänger aus der gleichen Heterostruktur-Halbleiterschichtenfolge und der gleichen PIN-Photodiode 17 aufgebaut wie im Ausführungsbeispiel 1. Jedoch ist in die n-dotierte Halbleiterschicht 1 im Bereich des HEMT 18 ein p-leitendes Gebiet 7a implantiert, auf das der Gate-Anschluß 11 des HEMT 18 aufgebracht ist (Fig. 4).

In den Ausführungsbeispielen 1 und 2 sind PIN-Photodiode 17 und HEMT 18 entweder in Mesabauweise (Fig. 3) oder quasi-planar (Fig. 4) angeordnet. In der quasi-planaren Anordnung ist die zweite Elektrode 12b der PIN-Photodiode 17 über ein n-leitendes Gebiet 22 mit der n-dotierten Halbleiterschicht 5 bzw. 3a verbunden. Außerdem werden durch Implantation, z.B. mit Fe, oder durch geeignete Ätzverfahren und nachfolgende Auffülltechniken, z.B. mit Polyimid, Isolationsgebiete 21,21a erzeugt. Ein erstes Isolationsgebiet 21 trennt die Elektroden 12b, 13 der PIN-Photodiode 17. Ein zweites Isolationsgebiet 21a ist zwischen PIN-Photodiode 17 und HEMT 18 eingebracht. (Fig. 4).

Die Funktionsweise eines PIN-HEMT-Photoempfängers ohne angekoppelten Wellenleiter jedoch mit ähnlichem Aufbau wie in den Ausführungsbeipielen 1 und 2 ist in der deutschen Patentanmeldung DE-A-37 12 684 beschrieben.

Im Ausführungsbeispiel 3 sind die Halbleiterschichten 2 bis 5 analog dem Ausführungsbeispiel 1 gewählt. Die Halbleiterschicht 1 ist jedoch p-leitend und besteht aus InP oder InGaAsP. Die Ladungsträgerkonzentration beträgt 10¹⁷ bis 10¹⁹ cm⁻³ und die Schichtdicke ist etwa 2 bis 100nm. Der Gate-Anschluß des HEMT 18 kontaktiert die p-leitende Halbleiterschicht 1. Source- und Drain-Anschluß 9,10 sind analog Ausführungsbeispiel 1 auf n-leitenden Gebieten 8,8a aufgebracht. Eine erste Elektrode 13 der PIN-Photodiode 17 kontaktiert die p-leitende Halbleiterschicht 1 und die zweite Elektrode 12 bzw. 12b ist je nach Mesa- oder planarer Bauform des Photoempfängers entsprechend den Ausführungsbeispielen 1 oder 2 angeordnet. In Fig. 5 ist eine planare Anordnung von PIN-Photodiode 17 und HEMT 18 für die im Ausführungsbeispiel 3 angegebene Heterostruktur gezeigt. Die Steuerung von PIN-Photodiode 17 und HEMT 18 erfolgt durch einen p/n-Übergang, der durch die p-dotierte Halbleiterschichten 1 und die n-dotierte Halbleiterschicht 2 gebildet wird.

Im Ausführungsbeispiel 4 sind auf einem halbisolierenden Substrat 6
- eine erste p-dotierte Halbleiterschicht 5 aus InAlAs oder InAlAsP oder InGaAsP oder InP mit einer Ladungsträgerkonzentration von 10¹⁷ bis 5·10¹⁸ cm⁻³ und einer Schichtdicke von 0,2 bis 2 µm ,und
- eine p-dotierte Halbleiterschicht 4 aus InAlAs oder InAlAsP oder InGaAsP mit einer Ladungsträgerkonzentration von 10¹⁵ bis 10¹⁷ cm⁻³ und einer Schichtdicke von 0,2 bis 2 µm
aufgewachsen.

Die weiteren Halbleiterschichten 1 bis 3 sind analog Ausführungsbeispiel 1 gewählt. Fig. 6 zeigt eine planare Anordnung von PIN-Photodiode 17 und HEMT 18 mit in diesem Falle p-leitendem Wellenleiter 16 gemäß einer Heterostruktur laut Ausführungsbeispiel 4.

Die erste Elektrode 13 der PIN-Photodiode 17 ist auf der n-leitenden Halbleiterschicht 1 aufgebracht. Die zweite Elektrode 12b der PIN-Photodiode 17 ist über ein p-leitendes Gebiet 22a mit der p-leitenden Halbleiterschicht 5 verbunden. Der steuernde p/n-Übergang der PIN-Photodiode 17 wird durch die gering n-dotierte Halbleiterschichten 3 und die p-dotierte Halbleiterschicht 4 erzeugt.

Source und Drain-Anschluß 9, 10 des HEMT 18 kontaktieren die n-leitende Halbleiterschicht 1. Im Bereich des Gate-Anschlusses 11 des HEMT 18 ist die n-dotierte Halbleiterschicht 1 weggeätzt und der sperrende metallische Kontakt ist auf die n-dotierte Halbleiterschicht 2 aufgebracht.

Die Isolierung von PIN-Photodiode 17 und HEMT 18 in der planaren Anordnung wird durch ionen-implantierte (z.B. mit Fe) oder geätzte und anschließend mit z.B. Polyimid aufgefüllten Gebieten 21, 21a erreicht.

Die aus der Heterostruktur-Halbleiterschichtenfolge gemäß Ausführungsbeispiel 4 aufgebaute PIN-Photodiode 17 und der HEMT 18 können auch in Mesabauweise angeordnet sein.

In allen Ausführungsbeispielen sind die Elektroden 12, 12b, 13 der PIN-Photodiode 17 und die elektrischen Anschlüsse 9,10,11 des HEMT 18 metallische Kontakte aus z.B. einer Au/Ge- oder Au/Zn-Legierung. Die elektrischen Kontakte der einzelnen Bauelemente des Photoempfängers können beispielsweise über metallische Leiterbahnen in geeigneter Weise miteinander verknüpft werden.

Die Oberfläche des Photoempfängers ist vorteilhafterweise mit einer Oxidschicht 14 überzogen, die als Passivierungsschicht und/oder als Implantationsfenster sowie für die Kontaktstrukturierung geeignet ist.

Für die p-Dotierung verwendete Materialien sind beispielsweise Be, Mg oder Zn und für die n-Dotierung Si, S oder Sn.

Zur Verbesserung der Sperreigenschaften des Gate-Anschlusses 11 ist es vorteilhaft, die Dotierung der n-dotierten Halbleiterschicht 2 in vertikaler Richtung zu variieren, derart, daß die Dotierkonzentration zur Halbleiterschicht 1 auf Null abnimmt.

PIN-HEMT-Photoempfänger ohne integrierten Wellenleiter aber mit einer ähnlichen elektronischen Signalverarbeitung wie in den Ausführungsbeispielen 3 und 4 sind in den Patentanmeldungen EP-A-0 258 530 und DE-A-36 29 684 beschrieben.

Monolithisch integrierte Photoempfänger gemäß der Erfindung lassen sich mit Hilfe der Molekularstrahl-Epitaxie oder der chemischen Gasphasen-Epitaxie aus metallorganischen Verbindungen herstellen.

Die Erfindung ist nicht auf die beschriebenen Ausführungsbeispiele beschränkt, sondern es kann zum Beispiel das Substrat 6 aus n- oder p-leitendem InP oder Si bestehen, auf dem eine undotierte Pufferschicht aus InP aufgebracht ist. Die Pufferschicht begrenzt Kristalldefekte im wesentlichen auf die Grenzfläche Substrat/Pufferschicht. Weiterhin können die Pfufferschicht, die n-dotierte Halbleiterschichten 2, und die undotierte Halbleiterschicht 2a der in den Ausführungsbeispielen beschriebenen Heterostruktur als Übergitter aufgebaut sein. Geeignete Materialien zur Bildung eines entsprechenden Übergitters sind z.B. InAs/InP oder GaAs/InGaAsP oder GaP/InGaAsP.

## Patentansprüche

1. Monolithisch integrierter Photoempfänger bestehend aus einer auf einem Substrat (6) aufgebrachten Heterostruktur-Halbleiterschichtenfolge, welche einen optischen Wellenleiter (16) und zumindest eine PIN-Photodiode (17) enthält, wobei der Wellenleiter zur Zuführung von dem eingestrahlten Licht an die PIN-Photodiode zumindest eine lichtführende, zweite Halbleiterschicht (4) besitzt, die auf einer auf dem Substrat angeordneten ersten Halbleiterschicht (5) der Halbleiter-Schichtenfolge aufgewachsen ist und einen größeren Brechungsindex als die erste Halbleiterschicht aufweist, und wobei die erste und die lichtführende, zweite Halbleiterschicht Bestandteil der PIN-Photodiode sind, dadurch gekennzeichnet, daß die Halbleiterschichtenfolge zumindest einen der Photodiode zugehörigen Verstärker mit mindestens einem HEMT (18) mit einem Gate-Anschluß (11), einem Source-Anschluß (9) und einem Drain-Anschluß (10) enthält, daß das Substrat (6) halbisolierend ist, daß die erste Halbleiterschicht (5) eine leitende Kontaktschicht für eine auf der lichtführenden, zweiten Schicht (4) aufgewachsene, dritte Halbleiterschicht (3) der PIN-Photodiode bildet, wobei die erste Halbleiterschicht (5) mit einer ersten Elektrode (12, 12b) der PIN-Photodiode (17) kontaktiert ist.

2. Photoempfänger nach Anspruch 1, dadurch gekennzeichnet, daß die auf der lichtführenden Halbleiterschicht (4) aufgewachsene, dritte Halbleiterschicht (3) der Halbleiterschichtenfolge einen größeren Brechungsindex als die lichtführende, zweite Halbleiterschicht (4) aufweist und undotiert oder mit einer Dotierkonzentration von 10¹⁴ bis 10¹⁶cm-3 gering dotiert ist.

3. Monolithisch integrierter Photoempfänger nach einem der vorhergehenden Ansprüche, dadurch gekennzeichnet, daß auf dem Substrat (6) eine Heterostruktur-Halbleiterschichtenfolge aus einer n-dotierten, ersten Halbleiterschicht (5) mit einer Dotierkonzentration von 10¹⁷ bis 5 · 10¹⁸cm⁻³ einer n-dotierten, zweiten Halbleiterschicht (4) mit einer Dotierkonzentration von 10¹⁵ bis 10¹⁷cm⁻³, einer undotierten oder mit einer Dotierkonzentration von 10¹⁴ bis 10¹⁶cm⁻³ lediglich gering n-dotierten, dritten Halbleiterschicht (3), einer undotierten, vierten Halbleiterschicht (2a), einer n-dotierten, fünften Halbleiterschicht (2) mit einer Dotierkonzentration von 10¹⁷ bis 10¹⁸cm⁻³ und einer n-dotierten, sechsten Halbleiterschicht (1) mit einer Dotierkonzentration von 10¹⁸cm⁻³ bis 6 · 10¹⁸cm⁻³ aufgewachsen ist.

4. Monolithisch integrierter Photoempfänger nach Anspruch 3, dadurch gekennzeichnet,
- daß die sechste Halbleiterschicht (1) im Bereich des Gate-Anschlusses (11) des HEMT (18) entfernt ist, und
- daß der Gate-Anschluß (11) des HEMT (18) die fünfte Halbleiterschicht (2) kontaktiert.

5. Monolithisch integrierter Photoempfänger nach Anspruch 3, dadurch gekennzeichnet, daß die sechste Halbleiterschicht (1) im Bereich des HEMT (18) ein p-dotiertes Gebiet (7a) enthält auf dem der Gate-Anschluß (11) des HEMT (18) aufgebracht ist.

6. Monolithisch integrierter Photoempfänger nach Anspruch 4 oder 5, dadurch gekennzeichnet,
- daß im Bereich der PIN-Photodiode (17) die sechste Halbleiterschicht (1), die fünfte Halbleiterschicht (2) und die vierte Halbleiterschicht (2a) entfernt sind,
und
- daß die dritte Halbleiterschicht (3) der PIN-Photodiode (17) ein p-dotiertes Gebiet (7) enthält, auf dem eine zweite Elektrode (13) der PIN-Photodiode (17) aufgebracht ist.

7. Monolithisch integrierter Photoempfänger nach einem der Ansprüche 1 bis 2, dadurch gekennzeichnet,
- daß auf dem Substrat (6) eine Heterostruktur-Halbleiterschichtenfolge aus einer n-dotierten, ersten Halbleiterschicht (5) mit einer Dotierkonzentration von 10¹⁷ bis 5 · 10¹⁸cm⁻³, einer n-dotierten, zweiten Halbleiterschicht (4) mit einer Dotierkonzentration von 10¹⁵ bis 10¹⁷cm⁻³, einer undotierten oder lediglich gering n-dotierten, dritten Halbleiterschicht (3) mit einer Dotierkonzentration von 10¹⁴ bis 10¹⁶cm⁻³, einer undotierten, vierten Halbleiterschicht (2a), einer n-dotierten, fünften Halbleiterschicht (2) mit einer Dotierkonzentration von 10¹⁷ bis 10¹⁸cm⁻³ und einer p-dotierten, sechsten Halbleiterschicht (1) mit einer Dotierkonzentration von 10¹⁷ bis 10¹⁹cm⁻³ aufgewachsen ist,
- daß der Gate-Anschluß (11) des HEMT (18) die sechste Halbleiterschicht (1) kontaktiert, und
- daß eine zweite Elektrode (13) der PIN-Photodiode (17) auf die sechste Halbleiterschicht (1) aufgebracht ist.

8. Monolithisch integrierter Photoempfänger nach einem der Ansprüche 3 bis 7, dadurch gekennzeichnet, daß der Source- und Drain-Anschluß (9, 10) des HEMT (18) auf n-dotierten Gebieten (8, 8a) aufgebracht sind, die senkrecht zu den vierten bis sechsten Halbleiterschichten (1, 2, 2a) verlaufen und bis in die dritte Halbleiterschicht (3) reichen.

9. Monolithisch integrierter Photoempfänger nach einem der Ansprüche 1 und 2, dadurch gekennzeichnet,
- daß auf dem Substrat (6) eine Heterostruktur-Halbleiterschichtenfolge aus einer p-dotierten, ersten Halbleiterschicht (5) mit einer Dotierkonzentration von 10¹⁷ bis 5 · 10¹⁸cm⁻³, einer p-dotierten, zweiten Halbleiterschicht (4) mit einer Dotierkonzentration von 10¹⁵ bis 10¹⁷cm⁻³, einer undotierten oder mit einer Dotierkonzentration von 10¹⁴ bis 10¹⁶cm⁻³ lediglich gering n-dotierten, dritten Halbleiterschicht (3), einer undotierten, vierten Halbleiterschicht (2a), einer n-dotierten, fünften Halbleiterschicht (2) mit einer Dotierkonzentration zwischen 10¹⁷ und 10¹⁸cm⁻³ und einer n-dotierten, sechsten Halbleiterschicht (1) mit einer Dotierkonzentration von 10¹⁸cm⁻³ bis 6 · 10¹⁸cm⁻³ aufgebracht ist,
- daß die sechste Halbleiterschicht (1) im Bereich des Gate-Anschlusses (11) des HEMT (18) entfernt ist,
- daß der Gate Anschluß (11) des HEMT (18) die fünfte Halbleiterschicht (2) kontaktiert,
- daß Source- und Drain-Anschluß (9, 10) des HEMT (18) die sechste Halbleiterschicht (1) kontaktieren und
- daß eine zweite Elektrode (13) der PIN-Photodiode (17) auf die sechste Halbleiterschicht (1) aufgebracht ist.

10. Monolithisch integrierter Photoempfänger nach einem der vorhergehenden Ansprüche, dadurch gekennzeichnet, daß PIN-Photodiode (17) und HEMT (18) in Mesabauweise angeordnet sind.

11. Monolithisch integrierter Photoempfänger nach einem der Ansprüche 1 bis 6 und Anspruch 8, dadurch gekennzeichnet, daß PIN-Photodiode (17) und HEMT (18) quasiplanar angeordnet sind.

12. Monolithisch integrierter Photoempfänger nach den Ansprüchen 1 und 2 und den Ansprüchen 7 bis 9, dadurch gekennzeichnet, daß PIN-Photodiode (17) und HEMT (18) planar angeordnet sind.

13. Monolithisch integrierter Photoempfänger nach einem der Ansprüche 1 bis 9 und den Ansprüchen 11 und 12, dadurch gekennzeichnet, daß PIN-Photodiode (17) und HEMT (18) durch ein Isolationsgebiet (21a) getrennt sind, das senkrecht zu den Halbleiterschichten verläuft und bis ins Substrat (6) reicht.

14. Monolithisch integrierter Photoempfänger bestehend aus einer auf einem Substrat (6) aufgebrachten Heterostruktur-Halbleiterschichtenfolge, welche einen optischen Wellenleiter (16) und zumindest eine PIN-Photodiode (17) enthält, wobei der Wellenleiter zur Zuführung von dem eingestrahlten Licht an die PIN-Photodiode zumindest eine lichtführende, zweite Halbleiterschicht (4) besitzt, die auf einer auf dem Substrat angeordneten ersten Halbleiterschicht (5) der Halbleiter-Schichtenfolge aufgewachsen ist und einen größeren Brechungsindex als die erste Halbleiterschicht aufweist, und wobei die erste und die lichtführende, zweite Halbleiterschicht Bestandteil der PIN-Photodiode sind, dadurch gekennzeichnet, daß die Halbleiterschichtenfolge zumindest einen der Photodiode zugehörigen Verstärker mit mindestens einem HEMT (18) mit einem Gate-Anschluß (11), einem Source-Anschluß (9) und einem Drain-Anschluß (10) enthält, daß das Substrat (6) halbisolierend ist, daß die erste Halbleiterschicht (5) eine Pufferschicht ist, daß auf der lichtführenden, zweiten Halbleiterschicht (4) eine leitende Kontaktschicht (3a) für eine auf der leitenden Kontaktschicht (3a) aufgewachsene, dritte Halbleiterschicht (3) der PIN-Photodiode, die einen Brechungsindex besitzt, der zwischen dem der lichtführenden, zweiten Halbleiterschicht (4) und dem der dritten Halbleiterschicht (3) liegt, aufgewachsen ist, wobei die leitende Kontaktschicht (3a) mit einer ersten Elektrode (12b) der PIN-Photodiode kontaktiert ist.

15. Monolithisch integrierter Photoempfänger nach Anspruch 14, dadurch gekennzeichnet, daß die leitende Kontaktschicht (3a) n-dotiert mit einer Dotierkonzentration von 10¹⁷ bis 5·10¹⁸ cm⁻³ ist.

16. Monolithisch integrierter Photoempfänger nach einem der vorhergehenden Ansprüche, dadurch gekennzeichnet, daß die Halbleitermaterialien der Heterostruktur-Halbleiterschichtenfolgen so gewählt sind, daß der Wellenlängenbereich λ des Photoempfängers zwischen 0,8µm und 1,55µm liegt.

## Claims

1. Monolithically integrated photo-receiver consisting of a heterostructure semiconductor layer sequence which is applied onto a substrate (6) and contains an optical wave guide (16) and at least one PIN photo-diode (17), wherein the wave guide - for the feeding of the inwardly radiated light to the PIN photodiode - comprises at least one light-conducting second semiconductor layer (4), which is grown onto a first semiconductor layer (5), which is arranged on the substrate, of the semiconductor layer sequence and displays a greater refractive index than the first semiconductor layer and wherein the first and the light-conducting second semiconductor layer are component of the PIN photodiode, characterised thereby, that the semiconductor layer sequence contains at least one amplifier belonging to the photo-diode with at least one HEMT (18) with a gate connection (11), a source connection (9) and a drain connection (10), that the substrate (6) is semi-insulating, that the first semiconductor layer (5) forms a conductive contact layer for a third semiconductor layer (3), which is grown onto the light-conducting second layer (4), of the PIN photo-diode, wherein the first semiconductor layer (5) is in contact with a first electrode (12, 12b) of the PIN photo diode (17).

2. Photo-receiver according to claim 1, characterised thereby, that the third semiconductor layer (3), which is grown onto the light-conducting semiconductor layer (4), of the semiconductor layer sequence has a greater refractive index than the light-conducting second semiconductor layer (4) and is either not doped or doped slightly with a doping concentration of 10¹⁴ to 10¹⁶ cm⁻³.

3. Monolithically integrated photo-receiver according to one of the preceding claims, characterised thereby, that a heterostructure semiconductor layer sequence of an n-doped first semiconductor layer (5) with a doping concentration of 10¹⁷ to 5·10¹⁸ cm⁻³, an n-doped second semiconductor layer (4) with a doping concentration of 10¹⁵ to 10¹⁷ cm⁻³, a third semiconductor layer (3), which is either not doped or merely slightly n-doped with a doping concentration of 10¹⁴ to 10¹⁶ cm⁻³, an undoped fourth semiconductor layer (2a), an n-doped fifth semiconductor layer (2) with a doping concentration of 10¹⁷ to 10¹⁸ cm⁻³ and an n-doped sixth semiconductor layer (1) with a doping concentration of 10¹⁸ cm⁻³ to 6·10¹⁸ cm⁻³ is grown onto the substrate (6).

4. Monolithically integrated photo-receiver according to claim 3, characterised thereby,
- that the sixth semiconductor layer (1) is removed in the region of the gate connection (11) of the HEMT (18) and
- that the gate connection (11) of the HEMT (18) makes contact with the fifth semiconductor layer (2).

5. Monolithically integrated photo-receiver according to claim 3, characterised thereby, that the sixth semiconductor layer (1) in the region of the HEMT (18) contains a p-doped region (7a), onto which the gate connection (11) of the HEMT (18) is applied.

6. Monolithically integrated photo-receiver according to claim 4 or 5, characterised thereby,
- that the sixth semiconductor layer (1), the fifth semiconductor layer (2) and the fourth semiconductor layer (2a) are removed in the region of the PIN photo diode (17) and
- that the third semiconductor layer (3) of the PIN photo diode (17) contains a p-doped region (7), onto which a second electrode (13) of the PIN photo diode (17) is applied.

7. Monolithically integrated photo-receiver according to one of the claims 1 and 2, characterised thereby,
- that a heterostructure semiconductor layer sequence of an n-doped first semiconductor layer (5) with a doping concentration of 10¹⁷ to 5·10¹⁸cm⁻³, an n-doped second semiconductor layer (4) with a doping concentration of 10¹⁵ to 10¹⁷ cm⁻³, a third semiconductor layer (3), which is either not doped or merely slightly n-doped with a doping concentration of 10¹⁴ to 10¹⁶ cm⁻³, an undoped fourth semiconductor layer (2a), an n-doped fifth semiconductor layer (2) with a doping concentration of 10¹⁷ to 10¹⁸ cm⁻³ and a p-doped sixth semiconductor layer (1) with a doping concentration of 10¹⁷ to 10¹⁹ cm⁻³ is grown onto the substrate (6),
- that the gate connection (11) of the HEMT (18) makes contact with the sixth semiconductor layer (1) and
- that a second electrode (13) of the PIN photo diode (17) is applied onto the sixth semiconductor layer (1).

8. Monolithically integrated photo-receiver according to one of the claims 3 to 7, characterised thereby, that the source and drain connections (9, 10) of the HEMT (18) are applied onto n-doped regions (8, 8a), which extend perpendicularly to the fourth, fifth and sixth semiconductor layers (1, 2, 2a) and reach into the third semiconductor layer (3).

9. Monolithically integrated photo-receiver according to one of the claims 1 and 2, characterised thereby,
- that a heterostructure semiconductor layer sequence of a p-doped first semiconductor layer (5) with a doping concentration of 10¹⁷ to 5·10¹⁸ cm⁻³, a p-doped second semiconductor layer (4) with a doping concentration of 10¹⁵ to 10¹⁷ cm⁻³, a third semiconductor layer (3), which is either not doped or merely slightly n-doped with a doping concentration of 10¹⁴ to 10¹⁶ cm⁻³, an undoped fourth semiconductor layer (2a), an n-doped fifth semiconductor layer (2) with a doping concentration of 10¹⁷ to 10¹⁸ cm⁻³ and an n-doped sixth semiconductor layer (1) with a doping concentration of 10¹⁸ cm⁻³ to 6·10¹⁸ cm⁻³ is grown onto the substrate (6).
- that the sixth semiconductor layer (1) is removed in the region of the gate connection (11) of the HEMT (18),
- that the gate connection (11) of the HEMT (18) makes contact with the fifth semiconductor layer (2),
- that the source and drain connections (9, 10) of the HEMT (18) make contact with the sixth semiconductor layer (1) and
- that a second electrode (13) of the PIN photo-diode (17) is applied onto the sixth semiconductor layer (1).

10. Monolithically integrated photo-receiver according to one of the preceding claims, characterised thereby, that the PIN photo-diode (17) and the HEMT (18) are arranged in mesa mode of construction.

11. Monolithically integrated photo-receiver according to one of the claims 1 to 6 and claim 8, characterised thereby, that the PIN photo-diode (17) and the HEMT (18) are arranged to be quasi-planar.

12. Monolithically integrated photo-receiver according to one of the claims 1 and 2 and the claims 7 to 9, characterised thereby, that the PIN photo-diode (17) and the HEMT (18) are arranged to be planar.

13. Monolithically integrated photo-receiver according to one of the claims 1 to 9 and the claims 11 and 12, characterised thereby, that the PIN photo-diode (17) and the HEMT (18) are separated by an insulating region (21a), which extends perpendicularly to the semiconductor layers and reaches into the substrate (6).

14. Monolithically integrated photo-receiver consisting of a heterostructure semiconductor layer sequence which is applied onto a substrate (6) and contains an optical wave guide (16) and at least one PIN photo-diode (17), wherein the wave guide - for the feeding of the inwardly radiated light to the PIN photodiode - comprises at least one light-conducting second semiconductor layer (4), which is grown onto a first semiconductor layer (5), which is arranged on the substrate, of the semiconductor layer sequence and displays a greater refractive index than the first semiconductor layer and wherein the first and the light-conducting second semiconductor layer are component of the PIN photo-diode, characterised thereby, that the semiconductor layer sequence contains at least one amplifier belonging to the photo-diode with at least one HEMT (18)with a gate connection (11), a source connection (9) and a drain connection (10), that the substrate (6) is semi-insulating, that the first semiconductor layer (5) is a buffer layer, that a conductive contact layer (3a), for a third semiconductor layer (3), which is grown onto the conductor contact layer (3a) and has a refractive index which lies between that of the light-conducting second semiconductor layer (4) and the third semiconductor layer (3), of the PIN photo-diode is grown onto the second light-conducting semiconductor layer (4) wherein the first semiconductor layer (5) is in contact with a first electrode (12, 12b) of the PIN photo-diode (17).

15. Monolithically integrated photo-receiver according to claim 14, characterised thereby, that the conductive contact layer (3a) is n-doped with a doping concentration of 10¹⁷ to 5·10¹⁸ cm⁻³.

16. Monolithically integrated photo-receiver according to one of the preceding claims, characterised thereby, that the semiconductor materials of the heterostructure semiconductor layer sequences are so chosen that the wavelength range of the photo-receiver lies between 0.8 to 1.55 micrometres.

## Revendications

1. Photodétecteur intégré monolithique, constitué par une succession de couches semi-conductrices à structure hétérogène appliquée sur un substrat (6), qui comporte un guide d'ondes optique (16) et au moins une photodiode PIN (17), le guide d'ondes possédant, pour l'amenée de la lumière incidente à la photodiode PIN, au moins une seconde couche semi-conductrice (4) menant la lumière qui est formée par croissance sur une première couche semi-conductrice (5) de la succession de couches semi-conductrices agencée sur le substrat, et qui présente un indice de réfraction supérieur à celui de la première couche semi-conductrice, la première couche semi-conductrice et la seconde couche semi-conductrice menant la lumière faisant partie de la photodiode PIN, caractérisé en ce que la succession de couches semi-conductrices comporte au moins un amplificateur associé à la photodiode et présentant au moins un HEMT (18) avec une borne de grille (11), une borne de source (9) et une borne de drain (10), en ce que le substrat (6) est semi-isolant, en ce que la première couche semi-conductrice (5) est une couche de contact conductrice pour une troisième couche semi-conductrice (3) de la photodiode PIN formée par croissance sur la seconde couche semi-conductrice (4) qui mène la lumière, la première couche semi-conductrice (5) étant en contact avec une première électrode (12, 12b) de la photodiode PIN (17).

2. Photodétecteur selon la revendication 1, caractérisé en ce que la troisième couche semi-conductrice (3) de la succession de couches semi-conductrices, qui est formée par croissance sur la couche semi-conductrice (4) menant la lumière présente un indice de réfraction supérieur à celui de la seconde couche semi-conductrice (4) menant la lumière, et en ce qu'elle n'est pas dopée ou bien dopée faiblement avec une concentration de dopage de 10¹⁴ à 10¹⁶ cm⁻³.

3. Photodétecteur intégré monolithique selon l'une ou l'autre des revendications précédentes, caractérisé en ce que sur le substrat (6) est formée par croissance une succession de couches semi-conductrices à structure hétérogène constituée par une première couche semi-conductrice (5) dopée en n présentant une concentration de dopage de 10¹⁷ à 5 · 10¹⁸ cm⁻³, par une seconde couche semi-conductrice (4) dopée en n présentant une concentration de dopage de 10¹⁵ à 10¹⁷ cm⁻³, par une troisième couche semi-conductrice (3) non dopée ou dopée en n uniquement faiblement présentant une concentration de dopage de 10¹⁴ à 10¹⁶ cm⁻³, par une quatrième couche semi-conductrice (2a) non dopée, par une cinquième couche semi-conductrice (2) dopée en n présentant une concentration de dopage de 10¹⁷ à 10¹⁸ cm⁻³, et par une sixième couche semi-conductrice (1) dopée en n présentant une concentration de dopage de 10¹⁸ cm⁻³ à 6 · 10¹⁸ cm⁻³.

4. Photodétecteur intégré monolithique selon la revendication 3, caractérisé en ce que :
- la sixième couche semi-conductrice (1) est enlevée dans la région de la borne de grille (11) du HEMT (18), et
- en ce que la borne de grille (11) du HEMT (18) est en contact avec la cinquième couche semi-conductrice (2).

5. Photodétecteur intégré monolithique selon la revendication 3, caractérisé en ce que la sixième couche semi-conductrice (1) comporte dans la région du HEMT (18) une zone (7a) dopée en p sur laquelle est appliquée la borne de grille (11) du HEMT (18).

6. Photodétecteur intégré monolithique selon l'une ou l'autre des revendications 4 et 5, caractérisé en ce que :
- dans la région de la photodiode PIN (17), la sixième couche semi-conductrice (1), la cinquième couche semi-conductrice (2) et la quatrième couche semi-conductrice (2a) sont enlevées, et
- en ce que la troisième couche semi-conductrice (3) de la photodiode PIN (17) comporte une zone (7) dopée en p sur laquelle est appliquée la seconde électrode (13) de la photodiode PIN (17).

7. Photodétecteur intégré monolithique selon l'une ou l'autre des revendications 1 et 2, caractérisé en ce que :
- sur le substrat (6) est formée par croissance une succession de couches semi-conductrices à structure hétérogène constituée par une première couche semi-conductrice (5) dopée en n présentant une concentration de dopage de 10¹⁷ à 5 · 10¹⁸ cm⁻³, par une seconde couche semi-conductrice (4) dopée en n présentant une concentration de dopage de 10¹⁵ à 10¹⁷cm⁻³, par une troisième couche semi-conductrice (3) non dopée ou uniquement faiblement dopée en n présentant une concentration de dopage de 10¹⁴ à 10¹⁶ cm⁻³, par une quatrième couche semi-conductrice (2a) non dopée, par une cinquième couche semi-conductrice (2) dopée en n présentant une concentration de dopage de 10¹⁷ à 10¹⁸ cm⁻³, et par une sixième couche semi-conductrice (1) dopée en p présentant une concentration de dopage de 10¹⁷ à 10¹⁹ cm⁻³,
- en ce que la borne de grille (11) du HEMT (18) est en contact avec la sixième couche semi-conductrice (1), et
- en ce qu'une seconde électrode (13) de la photodiode PIN (17) est appliquée sur la sixième couche semi-conductrice (1).

8. Photodétecteur intégré monolithique selon l'une quelconque des revendications 3 à 7, caractérisé en ce que les bornes de source et de drain (9, 10) du HEMT (18) sont appliquées sur des zones (8, 8a) dopées en n qui s'étendent perpendiculairement aux quatrième à sixième couches semi-conductrices (1, 2, 2a) et pénètrent jusqu'à la troisième couche semi-conductrice (3).

9. Photodétecteur intégré monolithique selon l'une ou l'autre des revendications 1 et 2, caractérisé en ce que :
- sur le substrat (6) est appliquée une succession de couches semi-conductrices à structure hétérogène constituée par une première couche semi-conductrice (5) dopée en p présentant une concentration de dopage de 10¹⁷ à 5 · 10¹⁸ cm⁻³, par une seconde couche semi-conductrice (4) dopée en p présentant une concentration de dopage de 10¹⁵ à 10¹⁷cm⁻³, par une troisième couche semi-conductrice (3) non dopée ou uniquement faiblement dopée en n présentant une concentration de dopage de 10¹⁴ à 10¹⁶ cm⁻³, par une quatrième couche semi-conductrice (2a) non dopée, par une cinquième couche semi-conductrice (2) dopée en n présentant une concentration de dopage de 10¹⁷ à 10¹⁸ cm⁻³, et par une sixième couche semi-conductrice (1) dopée en n présentant une concentration de dopage de 10¹⁸ cm⁻³ à 6 · 10¹⁸ cm⁻³,
- en ce que la sixième couche semi-conductrice (1) est enlevée dans la région de la borne de grille (11) du HEMT (18),
- en ce que la borne de grille (11) du HEMT (18) est en contact avec la cinquième couche semi-conductrice (2),
- en ce que les bornes de source et de drain (9, 10) du HEMT (18) sont en contact avec la sixième couche semi-conductrice (1), et
- en ce qu'une seconde électrode (13) de la photodiode PIN (17) est appliquée sur la sixième couche semi-conductrice (1).

10. Photodétecteur intégré monolithique selon l'une quelconque des revendications précédentes, caractérisé en ce que la photodiode PIN (17) et le HEMT (18) sont agencés en structure de type mesa.

11. Photodétecteur intégré monolithique selon l'une quelconque des revendications 1 à 6 et selon la revendication 8, caractérisé en ce que la photodiode PIN (17) et le HEMT (18) sont agencés de façon quasiment plane.

12. Photodétecteur intégré monolithique selon l'une quelconque des revendications 1 et 2 et 7 à 9, caractérisé en ce que la photodiode PIN (17) et le HEMT (18) sont agencés de façon plane.

13. Photodétecteur intégré monolithique selon l'une quelconque des revendications 1 à 9 et 11 et 12, caractérisé en ce que la photodiode PIN (17) et le HEMT (18) sont séparés par une zone d'isolation (21a) qui s'étend perpendiculairement aux couches semi-conductrices et qui pénètre jusqu'au substrat (6).

14. Photodétecteur intégré monolithique, constitué par une succession de couches semi-conductrices à structure hétérogène appliquée sur un substrat (6), qui comporte un guide d'ondes optique (16) et au moins une photodiode PIN (17), le guide d'ondes possédant, pour l'amenée de la lumière incidente à la photodiode PIN, au moins une seconde couche semi-conductrice (4) menant la lumière qui est formée par croissance sur une première couche semi-conductrice (5) de la succession de couches semi-conductrices agencée sur le substrat, et qui présente un indice de réfraction supérieur à celui de la première couche semi-conductrice, la première couche semi-conductrice et la seconde couche semi-conductrice menant la lumière faisant partie de la photodiode PIN, caractérisé en ce que la succession de couches semi-conductrices comporte au moins un amplificateur associé à la photodiode et présentant au moins un HEMT (18) avec une borne de grille (11), une borne de source (9) et une borne de drain (10), en ce que le substrat (6) est semi-isolant, en ce que la première couche semi-conductrice (5) est une couche tampon, en ce qu'il est formé par croissance sur la seconde couche semi-conductrice (4) menant la lumière une couche de contact conductrice (3a) pour une troisième couche semi-conductrice (3) de la photodiode PIN, qui est formée par croissance sur la couche de contact conductrice (3a) et qui possède un indice de réfraction situé entre celui de la seconde couche semi-conductrice (4) menant la lumière et celui de la troisième couche semi-conductrice (3), la couche de contact conductrice (3a) étant en contact avec une première électrode (12b) de la photodiode PIN.

15. Photodétecteur intégré monolithique selon la revendication 14, caractérisé en ce que la couche de contact conductrice (3a) est dopée en n présentant une concentration de dopage de 10¹⁷ à 5 · 10¹⁸ cm⁻³.

16. Photodétecteur intégré monolithique selon l'une quelconque des revendications précédentes, caractérisé en ce que les matériaux semi-conducteurs des successions de couches semi-conductrices à structure hétérogène sont choisis de telle sorte que la plage de longueur d'ondes λ du photodétecteur se trouve entre 0,8 µm et 1,55 µm.
